(19) Europäisches Patentamt
European Patent Office
Office européen des brevets

(11) Veröffentlichungsnummer: 0 258 719
A2

# (12) EUROPÄISCHE PATENTANMELDUNG

(21) Anmeldenummer: 87111854.3

(51) Int. Cl.⁴: G03F 7/02

(22) Anmeldetag: 17.08.87

Ein Antrag gemäss Regel 88 EPÜ auf Berichtigung der Beschreibung liegt vor. Über diesen Antrag wird im Laufe des Verfahrens vor der Prüfungsabteilung eine Entscheidung getroffen werden (Richtlinien für die Prüfung im EPA, A-V, 2.2).

(30) Priorität: 30.08.86 DE 3629543
31.01.87 DE 3702897

(43) Veröffentlichungstag der Anmeldung:
09.03.88 Patentblatt 88/10

(84) Benannte Vertragsstaaten:
AT BE CH DE ES FR GB IT LI NL SE

(71) Anmelder: Merck Patent Gesellschaft mit beschränkter Haftung
Frankfurter Strasse 250
D-6100 Darmstadt(DE)

(72) Erfinder: Köhler, Manfred, Dr.
Hebbelstrasse 38
D-6100 Darmstadt(DE)
Erfinder: Poetsch, Eike, Dr.
Am Buchwald 4
D-6109 Mühltal 6(DE)
Erfinder: Ohngemach, Jörg, Dr.
Taubenstrasse 6
D-6107 Reinheim 5(DE)
Erfinder: Dorsch, Dieter, Dr.
Reuterallee 24
D-6100 Darmstadt(DE)
Erfinder: Eidenschink, Rudolf, Dr.
Konrad-Adenauer-Strasse 1
D-6109 Mühltal(DE)
Erfinder: Greber, Gerhard, Prof. Dr.
Anzengruberstrasse 11
A-2540 Bad Vöslau(AT)

## (54) Zweischichtensystem.

(57) Strahlungshärtbare Zweischichtensysteme enthaltend immobilisierte Photoinitiatoren eignen sich zur Herstellung dickenkonstanter, gut haftender Beschichtungen und Reliefstrukturen hoher Auflösung und Kantensteilheit.

EP 0 258 719 A2

## Zweischichtensystem

Die Erfindung betrifft ein strahlungshärtbares Zweischichtensystem sowie dessen Verwendung zur Herstellung polymerer Beschichtungen.

Strahlungshärtbare Systeme sind begehrte und vielfältig eingesetzte Materialien bei der Herstellung photopolymerisierter Beschichtungen zur Oberflächenvergütung sowie bei der photolithographischen Erzeugung von photopolymerisierten Reliefstrukturen. Hauptanwendungsgebiet hierbei ist die Erzeugung von Lackbeschichtungen auf den unterschiedlichsten Substraten. Desweiteren können bei der Herstellung mikroelektronischer und optoelektronischer Bauelemente und Schaltungen solche Materialien als Fotoresist bei der Erzeugung der Schaltungsstrukturen oder in diesen als in besonderem Maße hitze-und chemikalienbeständige Schutz-oder Passivierungsschichten, als Isolationsschichten, Dielektrika oder bei Flüssigkristallanzeigezellen als Orientierungsschichten Verwendung finden. Weitere Anwendungen sind die Verwendung als Ätz-und Galvanoresist sowie als Lötstoplack bei der Herstellung von gedruckten Schaltungen sowie von Druckplatten und sonstigen reprographischen Materialien. Schließlich eignen sich derartige Systeme auch zur Herstellung anisotroper Polymerbeschichtungen zur Anwendung auf dem Gebiet der nichtlinearen Optik.

Die vielfältigen Methoden zur Herstellung strahlungshärtbarer Systeme können beispielsweise aus W.S. De Forest: Photoresist Materials and Processes, MacGraw-Hill, New York, 1975, sowie den DE-PS 23 80 830, DE-PS 24 37 348, DE-PS 27 22 264 und EP-PS 3002 entnommen werden.

Diese bisher bekannten Verfahren und Methoden weisen eine Reihe von Nachteilen auf. So ist die Empfindlichkeit häufig unbefriedigend, wodurch für eine ausreichende Fotovernetzung und die dadurch bedingte Schichthärte sowie für die Gewährleistung der in der Mikroelektronik erforderlichen Auflösung und Kantensteilheit der Reliefstrukturen mit den üblichen Strahlungsquellen Belichtungszeiten von mehreren Minuten erforderlich sind. Andererseits geben mangelndes Auflösungsvermögen und unbefriedigende Kantensteilheit, beispielsweise bewirkt durch Unterstrahlung der Kopierschicht oder durch Reflexion am Substrat, Anlaß zur Kritik an den bekannten photopolymerisierbaren Systemen.

Weiterhin problematisch bei Beschichtungen jeglicher Art ist die Haftung des Filmes auf dem Substrat. Insbesondere bei Substraten von unebener Formgebung oder stark biegebeanspruchten Materialien kommt es vielfach zum Ablösen der Beschichtung vom Untergrund.

Schließlich besteht oftmals ein Bedürfnis nach Schichten, deren Dicke in einem weiten Bereich homogen ist, was durch herkömmliche Beschichtungstechniken meist nur schwierig erreichbar ist.

Es besteht somit ein Bedürfnis nach einem strahlungshärtbaren System, welches die Herstellung dickenkonstanter, gut haftender Beschichtungen und im Falle einer photolithographischen Strukturierung Reliefstrukturen hoher Auflösung und Kantensteilheit erlaubt.

Diese Aufgabe wird gelöst durch das erfindungsgemäße strahlenhärtbare Zweischichtensystem.

Gegenstand der Erfindung ist daher ein strahlungshärtbares Zweischichtensystem, bestehend aus einer auf ein Substrat aufgebrachten, initiatorhaltigen Schicht und einer darüberliegenden, polymerisierbare Monomere oder Oligomere enthaltenden Schicht, dadurch gekennzeichnet, daß der Initiator an einer Makrostruktur immobilisiert ist.

Durch Strahlung härtbare Zweischichtensysteme sind bekannt. So lehrt US-4,551,418 die Beschichtung eines Substrats mit einem kationischen Photoinitiator, dessen Belichtung durch eine Kopierschicht hindurch stattfindet unter Erzeugung kationischer, initiierender Molekülbruchstücke und Kontaktieren der Initiatorschicht mit einem der kationischen Polymerisation zugänglichen Monomer, welches an den belichteten Stellen polymerisiert. Nach Entfernen der nicht polymerisierten Schichtenanteile durch Waschen wird eine Reliefstruktur erhalten. Nach diesem Verfahren hergestellte Beschichtungen leiden jedoch an den nämlichen, zuvor angegebenen Nachteilen. Insbesondere Substrathaftung und Kantensteilheit des polymerisierten Systems sind ungenügend und die Auswahl an Monomeren ist auf die vergleichsweise geringe Anzahl an der kationischen Polymerisation zugänglichen Verbindungen beschränkt.

Überraschenderweise wurde nun gefunden, daß ein Zweischichtensystem mit einem an einer Makrostruktur immobilisierten Initiator durch Strahlungshärtung zu dickenkonstanten, gut haftenden Beschichtungen und Reliefstrukturen hoher Auflösung und Kantensteilheit polymerisierbar ist.

Die Art der verwendeten Initiatoren ist frei. Es können, den jeweiligen Monomeren oder Oligomeren angepaßt, sowohl radikalisch als auch ionisch unter Strahlungseinwirkung zerfallende Initiatoren eingesetzt werden.

Eine Immobilisierung des Photoinitiators läßt sich z.B. durch physikalische Attraktion, wie durch Adsorption an Oberflächen in Einschlußverbindungen vom Typ der Clathrate oder durch Einbettung in rigide, makroreticulare Strukturen erreichen. Beispielsweise erhält man durch Lösen eines Photoinitiators in einer Polymermaterial-Lösung, Aufbringen auf eine Oberfläche und evaporative Entfernung des Lösungsmittels oder durch Aufbringen eines geschmolzenen, einen Photoinitiator enthaltenden Polymermaterials nach dessen Erstarren einen Substratüberzug, worin die Beweglichkeit des Initiators stark eingeschränkt ist.

Vorzugsweise ist der Initiator durch kovalente Bindung immobilisiert. Gemäß einem bevorzugten Gegenstand der vorliegenden Erfindung ist der Initiator kovalent an eine Polymermatrix gebunden. Hierfür geeignete Initiatoren entsprechen beispielsweise der Formel I,

Ar-CO-R   I

worin

Ar 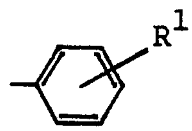

R   Ar-, $CR^2R^3R^4$,

$R^1$   H, Halogen, $C_1$-$C_{12}$ Alkyl, $C_1$-$C_{12}$Alkoxy, $C_1$-$C_{12}$ Alkylthio, A,

$R^2$, $R^3$   jeweils unabhängig voneinander H, $C_1$-$C_6$ Alkyl oder Phenyl, einer der Reste auch $C_1$-$C_6$ Alkylen-O-A und $R^2$ und $R^3$ zusammen auch $C_2$-$C_6$ Alkylen, $C_1$-$C_6$ Oxaalkylen,

$R^4$   $OR^5$, $N(R^5)_2$, $SR^5$, A,

$R^5$   H, $C_1$-$C_6$ Alkyl, $C_1$-$C_6$ Alkanoyl,

A   $(-ZC-CHZ-)_n$
$\qquad |$
$\qquad CO-X-(CH_2-CH_2-Y-)_m$

X   O, NH oder ($C_1$-$C_6$ Alkyl)N,

Y   O, N oder S,

Z   jeweils unabhängig voneinander H oder $CH_3$,

m   0 bis 4 und

n   2 bis $10^6$

bedeuten mit der Maßgabe, daß die Verbindungen der Formel I mindestens einen Rest der Formel A aufweisen.

Derartige Verbindungen sind beispielsweise in der EP-A-0161463 und DE-A-3534645 beschrieben.

Weiterhin bevorzugt im Rahmen der vorliegenden Erfindung sind kovalent an eine Substratoberfläche gebundene Initiatoren. Unter Substrat wird in diesem Zusammenhang jedwede beschichtbare Oberfläche wie z. B. Papier, Karton, Holz, Glas, Metall oder Polymermaterialien, verstanden. Über die an der Oberfläche dieser Materialien befindlichen reaktiven Gruppe erfolgt eine Bindung an den ebenfalls mit einer reaktiven Gruppe ausgestatteten Initiator. Als reaktive Gruppe besonders geeignet stellen sich entsprechend

substituierte Silane der Formel I dar, worin Ar, R, $R^1$, $R^2$, $R^3$, $R^4$, $R^5$, X, Y, Z, m und n die angegebene Bedeutung besitzen und hier A einen Rest

$$-W-Si-R^6_a R^7_b R^8_c$$

bedeutet, worin

$R^6$, $R^7$, $R^8$ jeweils H, F, Cl, Br, I, CN, NC, OCN, NCO, SCN, NCS oder $N_3$, $C_1$-$C_{15}$ Alkoxy, $C_1$-$C_{15}$ Alkanoyl,

W eine direkte Bindung oder $C_1$-$C_{20}$ Alkylen, worin auch eine oder zwei nicht benachbarte $CH_2$-Gruppen durch O, N oder S ersetzt sein können und

a, b und c 0, 1, 2 oder 3

bedeuten, mit der Maßgabe, daß a + b + c = 3 und mindestens einer der Substituenten X, Y, Z von H verschieden ist.

Derartige Silylgruppen enthaltende Initiatoren sind beispielsweise aus der EP-B-30 02 bekannt oder können nach Methoden, wie z. B. aus DE-A-35 21 201 oder DE-A-36 01 742 zu entnehmen, hergestellt werden.

Als polymerisierbare Verbindungen eignen sich sowohl zu einer durch freie Radikale als auch durch ionische Verbindungen initiierbaren Polymerisation befähigte mono-oder polyfunktionell ethylenisch ungesättigte Monomere, Oligomere oder Präpolymere oder deren Gemische. Der Stand der Technik bietet hierfür eine große Auswahl geeigneter Verbindungen.

Als ethylenisch ungesättigte Verbindungen eigenen sich beispielsweise Ethylen, Propylen, Buten, Isobutylen, Butadien, Isopren, Vinylchlorid, Vinylidenchlorid, Vinylidencyanid, Acrylsäure, Methacrylsäure, Acrylnitril, Methacrylnitril, Acrylamid, Methacrylamid, Methyl-, Ethyl-, n-oder tert. Butyl-, Cyclohexyl-, 2-Ethylhexyl-, Benzyl-, Phenoxyethyl-, Hydroxyethyl-, Hydroxypropyl-, niederes Alkoxyethyl-, Tetrahydrofurylacrylat oder -methacrylat, Vinylacetat, -propionat, -acrylat, -succinat, N-Vinylpyrrolidon, N-Vinylcarbazol, Styrol, Divinylbenzol, substituierte Styrole sowie die Mischungen von solchen ungesättigten Verbindungen. Auch mehrfach ungesättigte Verbindungen wie beispielsweise Ethylendiacrylat, 1,6-Hexandioldiacrylat, propoxyliertes Bisphenol-A-diacrylat und -dimethacrylat können in den erfindungsgemäßen Verfahren eingesetzt werden. Ethylenisch ungesättigte Verbindungen lassen sich radikalisch oder ionisch polymerisieren.

Zur ionischen Polymerisation geeignete Monomere sind beispielsweise Vinylether, cyclische Ester und Ether, Olefine oder weitere Verbindungen, wie z. B. in R. W. Lenz: Organic Chemistry of Synthetic High Polymers, Interscience Publ., New York, 1967, angeführt.

Der Ausdruck "Polymerisation" ist im weitesten Sinn zu verstehen. Darunter fällt z. B. das weitere Polymerisieren oder das Quervernetzen von polymeren Materialien, z. B. von Prepolymeren, die Homo-, Co-und Terpolymerisation von einfachen Monomeren und auch die Kombination der genannten Reaktionsarten.

Die zur Auslösung der Polymerisation benötigten Radikale oder ionischen Bruchstücke können auf verschiedene Weise entstehen, so z. B. durch Bestrahlung der Monomeren mit UV-Licht, Röntgenstrahlen oder radioaktiven Strahlenquellen.

Als Strahlenquellen können Sonnenlicht oder künstliche Strahler verwendet werden. Vorteilhaft sind z. B. Quecksilberdampf-Hochdruck-, -Mitteldruck-oder -Niederdrucklampen, Xenon-und Wolframlampen; Laser-Lichtquellen und Elektronenstrahlröhren können ebenfalls eingesetzt werden.

Die Herstellung der erfindungsgemäßen Zweischichtensysteme erfolgt in einfacher Weise durch Aufbringen eines Initiators oder Initiatorgemisches auf ein Substrat in gelöster oder flüssiger Form durch beispielsweise Bestreichen, Bedrucken, Tauchen oder Aufschleudern unter Erhalt einer mit kovalent gebundenem Initiator versehenden Makrostruktur und/oder einer an die Substratoberfläche kovalent verankerten Schicht von Initiatormolekülen.

Auf diese Initiatorschicht wird das gewünschte Monomere, Oligomere oder deren Gemische, ggf. in Anwesenheit von Zusatzstoffen, mittels voranstehend angegebener Techniken aufgebracht.

Solche Zusatzstoffe können z. B. Reaktionsbeschleuniger sein. Als Reaktionsbeschleuniger können beispielsweise organische Amine, Phosphine, Alkohole und/oder Thiole, die alle mindestens eine zum Heteroatom $\alpha$-ständige CH-Gruppe aufweisen, zugesetzt werden. Geeignet sind z. B. primäre, sekundäre und tertiäre aliphatische, aromatische, araliphatische oder heterocyclische Amine, wie sie z. B. in der US-PS 3,759,807 beschrieben sind. Beispiele für solche Amine sind Butylamin, Dibutylamin, Tributylamin, Cyclohexylamin, Benzyldimethylamin, Di-cyclohexylamin, Triethanolamin, N-Methyldiethanolamin, Phenyl-diethanolamin, Piperidin, Piperazin, Morpholin, Pyridin, Chinolin, p-Dimethylaminobenzoesäureethylester, p-Dimethylaminobenzoesäurebutylester, 4,4'-Bis-dimethylamino-benzophenon (Michlers Keton) oder 4,4'-Bis-diethylamino-benzophenon. Besonders bevorzugt sind tertiäre Amine wie beispielsweise Trimethylamin, Tri-isopropylamin, Tributylamin, Octyl-dimethylamin, Dodecyl-dimethylamin, Triethanolamin, N-Methyl-diethanolamin, N-Butyl-diethanolamin, Tris(hydroxypropyl)amin, Dimethylaminobenzoesäurealkylester.

Weiterhin kommen als Reaktionsbeschleuniger beispielsweise Trialkylphosphine, sekundäre Alkohole und Thiole in Frage.

Auch können geringe Mengen von Lichtstabilisatoren, wie beispielsweise Benzophenon-Derivate, Benztriazol-Derivate, Tetraalkylpiperidine oder Phenylsalicylate, zugesetzt werden.

Je nach Einsatzzweck eignen sich organische Zusatzstoffe, wie Thixotropiemittel, Verlaufsmittel, Bindemittel, Gleitmittel, Mattierungsmittel, Weichmacher, Netzmittel, Silikone zur Verbesserung der Oberflächenbeschaffenheit, Antiausschwimmittel oder geringe Mengen an Lösungsmitteln als Zusatz zu den zu polymerisierenden Monomeren.

Ein weiterer Gegenstand der vorliegenden Erfindung ist ein Verfahren zur Herstellung von polymeren Beschichtungen aus den erfindungsgemäßen Zweischichtensystemen. Hierzu bestrahlt man die auf der Initiatorschicht befindlichen Monomeren oder Oligomeren mit einer der vorerwähnten Lichtquellen, wobei eine gut haftende Polymerschicht erhalten wird, deren Dickenverteilung nahezu homogen ist und von der Dicke der ursprünglich aufgebrachten Monomeren-oder Oligomerenschicht weitgehend unabhängig ist. Nach der Bestrahlung werden über der Polymerschicht befindliche, nicht ausgehärtete Anteile durch Waschen mit einem geeigneten Lösungsmittel, wie z.B. von W.S. De Forest, ibid., beschrieben, entfernt.

In einer besonderen Ausführungsform wird das mit der Initiatorschicht versehene Substrat einfach in ein Medium, das die Monomeren bzw. Oligomeren enthält, eingetaucht und dann die Bestrahlung im eingetauchten Zustand durchgeführt. Hierbei wird nur im Grenzbereich Fotoinitiatorschicht/Medium die Fotopolymerisation ausgelöst, nicht im weiteren, das Substrat umgebenden Medium, sodaß also nur auf dem Substrat ein Polymerverband in Form einer homogenen, gut haftenden Beschichtung entsteht. Ein Vorteil dieser Verfahrensvariante ist, daß auch räumliche Gegenstände in einfacher Weise allseitig beschichtet werden können oder auch dünnflüssige Monomermaterialien oder Formulierungen wie beispielsweise Acrylsäurelösungen eingesetzt werden können, die sich nicht ohne weiteres als stabile Schicht von gleichmäßiger Dicke insbesondere auf nichtplane Oberflächen oder räumlich geformte Substrate aufbringen lassen.

Ebenfalls Gegenstand der vorliegenden Erfindung ist ein Verfahren zur Herstellung von Reliefstrukturen durch Bestrahlen der erfindungsgemäßen Zweischichtensysteme durch eine Kopierschicht. Die nach Entfernen der nicht der Bestrahlung ausgesetzten und somit nicht polymerisierten Bereiche durch Waschen erhaltenen Reliefstrukturen zeichnen sich durch einen hohen Auflösungsgrad und große Kantensteilheit aus.

Schließlich ist auch Gegenstand der Erfindung ein Verfahren zur photolithographischen Herstellung von Wellenleiterstrukturen für die integrierte Optik. So können durch Belichten eines erfindungsgemäßen Zweischichtensystems, gegebenenfalls durch eine Kopierschicht hindurch, Strukturen erzeugt werden, deren Brechungsindizes von denen des an sie angrenzenden Materials differieren. Derartige Strukturen eignen sich, beispielsweise nach Anbringung von Elektroden, als Wellenleiter und optische Schalter. Als vorteilhaft erweist sich in diesem Zusammenhang die Verwendung von Substraten, initiatorhaltigen Schichten oder Monomeren mit nichtlinearen optischen Eigenschaften.

Die Eigenschaften der erhaltenen Polymermaterialien lassen sich in an sich bekannter Weise durch Copolymerisation oder Vermischen mit weiteren Komponenten, durch Variation der Molekulargewichte, durch Zusätze der verschiedensten anorganischen oder organischen Additive und Metalle und durch viele weitere, dem Polymerfachmann geläufige Behandlungen modifizieren.

Die erfindungsgemäßen Zweischichtensysteme lassen sich vorteilhaft für die Beschichtung von z.B. Papier-, Glas-, Kunststoff und Metall mit strahlungshärtbaren Lackformulierungen einsetzen.

Mit ihrer Hilfe lassen sich auf photolithographischem Weg Reliefstrukturen erzeugen, die als Druckplatten, Fotoresists und elektronische Schaltelemente Verwendung finden.

Weitere Anwendungsmöglichkeiten erschließen sich auf dem Gebiet der integrierten Optik. Insbesondere eignen sich die erfindungsgemäßen Zusammensetzungen zur Herstellung von Wellenleitern, optischen Schaltanordnungen und optischen Datenspeichern.

Zur Erläuterung der Erfindung dienen folgende Beispiele:

Beispiel 1

Herstellung von Poly-[4-(2-acryloyloxyethoxy)-phenyl]-2-hydroxy-2-propylketon

30 g [4-(2-Acryloyloxyethoxy)-phenyl]-2-hydroxy-2-propylketon, 200 ml Tetrahydrofuran und 0,30 g Dibenzoylperoxid werden bei Raumtemperatur zusammengegeben und 15-20 Stunden am Rückfluß erhitzt. Das Lösungsmittel wird dann am Rotationsverdampfer entfernt und der Rückstand mit 0,5 g Aktivkohle versetzt, verrührt, filtriert und das Filtrat wird dann mit 300 ml n-Hexan versetzt. Die überstehende Lösung wird vom abgeschiedenen Produkt abdekantiert und dieser Umfällungsprozeß wird noch zweimal wiederholt. Das Produkt ergibt nach dem Trocknen bei Raumtemperatur eine amorphe, feste Masse, die in den üblichen organischen Lösungsmitteln (Aceton, Dichlormethan, Essigsäureethylester) leicht löslich ist; mittlere Molmasse: ca. 4000 (gelpermeationschromatographisch bestimmt); Glasübergangstemperatur Tg: 45-50°.

Beispiel 2

Belichtung von Poly-[4-(2-acryloyloxyethoxy)-phenyl]-2-hydroxy-2-propylketon und Trimethylolpropantriacrylat

Eine Lösung von Poly-[4-2-acryloyloxyethoxy)-phenyl]-2-hydroxy-2-propylketon in Aceton wird so auf eine Glasfläche aufgetragen, daß nach dem Abdunsten des Lösungsmittels eine dünne Schicht verbleibt. Auf diese wird Trimethylolpropantriacrylat aufgetragen. Diese Beschichtung wird an bestimmten Stellen abgedeckt und dann für ca. 30 Sekunden mit einem Hg-Mitteldruck-Brenner bestrahlt. Danach wird die Schicht mehrmals mit Aceton gewaschen, wobei sie an den abgedeckten Bereichen in Lösung geht und an den belichteten Stellen in scharfen Konturen als harte unlösliche Schicht auf der Glasfläche haftet.

Beispiel 3

Herstellung von Poly-[4-(2-methacryloyloxyethoxy)-phenyl]-2-hydroxy-2-propylketon

7,0 g [4-(2-Methacryloyloxyethoxy)-phenyl]-2-hydroxy-2-propylketon, 100 ml Essigsäureethylester und 0,15 g Dibenzoylperoxid werden bei Raumtemperatur zusammen gegeben und am Rückfluß gekocht. Nach 2 und 6 Stunden werden jeweils noch 0,15 g Dibenzoylperoxid zugesetzt und die Lösung wird insgesamt 15-20 Stunden am Rückfluß gekocht. Danach wird am Rotationsverdampfer das Lösungsmittel entfernt und der Rückstand in 100 ml Aceton unter Rühren gelöst und filtriert. Das Einengen des Filtrats und Trocknen des Rückstandes bei Raumtemperatur ergibt einen amorphen Feststoff; mittlere Molmasse: ca. 12 000; Tg: ca. 55°.

Beispiel 4

Belichtung von Poly-[4-(2-methacryloyloxyethoxy)-phenyl]-2-hydroxy-2-propylketon und Trimethylolpropantriacrylat

Eine 10 %ige Lösung von Poly-[4-(2-methacryloyloxyethoxy)-phenyl]-2-hydroxy-2-propylketon in Aceton wird 30 sec bei 4500 Upm auf Aluminiumblech aufgeschleudert. Das mit dem polymeren Initiator beschichtete Substrat wird anschließend 15 Minuten bei 90° getrocknet. Hernach schleudert man 5 sec bei 2000 Upm Trimethylolpropantriacrylat auf.

Zur Belichtung werden die mit dem Zweischichtensystem versehenen Aluminiumbleche auf einem Transportband mit einer Geschwindigkeit von 2,5 m/min unter zwei Quecksilbermitteldrucklampen (Strahlungsleistung 2 × 80 Watt/cm) vorbeigeführt und dabei ausgehärtet.

Man erhält eine gut haftende Beschichtung, die auch nach mehrmaligem Biegen des Substrates keinerlei Neigung zu Bruch oder Abblättern zeigt. Die mit Hilfe eines Dickenmeßgeräts ermittelten Werte für die Schichtstärke liegen über den gesamten Bereich der Beschichtung bei 0,635 ± 0,015 µm.

Beispiel 5

Herstellung einer Wellenleiterstruktur

Ein mit Methyl-N-(2,4-dinitrophenyl)-alaninat (MAP) dotiertes Vinylidenpolymerisat nach EP-A-0186999 wird mit einer 10 %igen Lösung von α-(3-Triethoxysilyl-propyl)-benzoin (DE-A-36 24 898) in Ethanol bestrichen. Nach Verdampfen des Lösungsmittels bei 40° wird auf die Initiatorschicht mittels einer Spiralrakel eine 5 µm dicke Schicht von Trimethylolpropantriacrylat aufgebracht. Man bestrahlt das System durch eine Kopierschicht 5 Min. mit einer Quecksilberdampflampe. Nach Entfernen von ungehärtetem Monomeren durch Spülen mit Aceton wird eine Wellenleitstruktur mit unterschiedlichen Brechungsindizes erhalten.

Beispiel 6

Tauchbeschichtung

Ein Stück Aluminiumfolie wird mit einer ca. 20 %igen Lösung des polymeren Fotoinitiators aus Beispiel 1 in Aceton bestrichen und dann 10 Minuten bei 100 °C getrocknet. Hernach wird die beschichtete Folie in eine 50 %ige wäßrige Acrylsäurelösung eingelegt und durch die Lösung hindurch 1 Minute mit einem Quecksilber-Hochdruckbrenner bestrahlt. Nach Entnahme aus der Lösung und Waschen mit Wasser findet sich auf der Folie eine gut haftende Polyacrylsäureschicht, die in Wasser quellfähig ist. In der Monomerlösung hat keine beobachtbare Polymerisation stattgefunden.

Beispiel 7 (Vergleich)

Eine Aluminiumfolie wird mit einer acetonischen Lösung des nichtpolymeren Fotoinitiators Phenyl-2-hydroxy-2-propylketon bestrichen und dann analog zu Beispiel 6 weiterbehandelt. Bei der Bestrahlung tritt ein Gelieren durch Polymerisation praktisch der gesamten flüssigen Phase ein. Eine brauchbare Beschichtung wird nicht erhalten.

Beispiel 8

Eine wie in Beispiel 6 vorbehandelte Aluminiumfolie wird in 2-Hydroxyethylacrylat eingelegt und in analoger Weise bestrahlt. Man erhält eine gut haftende gelartige Beschichtung. In der flüssigen Monomerphase tritt keine Veränderung ein.

Beispiel 9

Ein Tonscherben wird mit einer ca. 20 %igen acetonischen Lösung des polymeren Fotoinitiators aus Beispiel 1 getränkt und dann 10 Minuten bei 100 °C getrocknet. Hernach wird dieser in eine 50 %ige wäßrige Acrylsäurelösung eingehängt und durch die Lösung hindurch allseitig bestrahlt. Nach Herausnahme aus der ansonsten unverändert gebliebenen Monomerlösung und Waschen mit Wasser zeigt sich der Scherben allseitig von einer gleichmäßigen Polymerschicht umhüllt.

Beispiel 10

Von einer 20 %igen acetonischen Lösung des polymeren Fotoinitiators aus Beispiel 1 wurde etwa 1 ml auf eine Glasplatte (5 cm × 5 cm) aufgetragen und dann im Schleuderverfahren (1 Sekunde bei 2000 Upm) in homogener Schicht aufgebracht. Zur Entfernung des Lösungsmittels wurde die beschichtete Glasplatte in einem Trockenschrank 15 Minuten bei 90 °C erwärmt. Anschließend wurde die Dicke der aufgebrachten Schicht mit einem Schichtdickenmessgerät ("Alpha-Step 200", Fa. Tencor Instruments) zu 1,9-2,1 µm gemessen.

Die Glasplatte wurde dann in ein als Reaktionsgefäß dienendes Tauchrohr aus Quarz gestellt und mit einer Lösung bestehend aus 97 Gew.-Teilen-Hexan, 5 Gew.-Teilen-2-Propanol, und 3 Gew.-Teilen Trimethylolpropantriacrylat bedeckt. Auf dem Reaktionsgefäß wurde ein Rückflußkühler angebracht.

In einem Abstand von 7 cm wurde parallel zu dem Tauchrohr eine UV-Lampe (Typ TQ 180, Fa. Heraeus Original Hanau) so montiert, daß die in dem Tauchrohr befindliche, mit dem polymeren Fotoinitiator beschichtete Glasplatte optimal mit UV-Licht bestrahlt werden konnte. Nach einer Bestrahlungsdauer von 20 Minuten wurde die bestrahlte Glasplatte aus dem Reaktionsgefäß geholt, mit Aceton abgespült und dann 10 Minuten bei 90 °C getrocknet. Anschließend wurde die Dicke der Schicht gemessen. Sie betrug 2,5-2,6 µm. Die Schicht ist demnach während der Bestrahlung mit UV-Licht durch Aufpolymerisation des Trimethylolpropantriacrylates aus der Lösung um etwa 0,5 µm dicker geworden. In einem folgenden Versuch, der in entsprechender Weise durchgeführt wurde, wurde der Belichtungsabstand auf 5 cm verkürzt und die Belichtungszeit auf 40 Minuten verlängert. Die Dicke der dabei erhaltenen Schicht betrug 4,7-4,8 µm. Sie ist demnach während der UV-Bestrahlung um etwa 2,75 µm dicker geworden.

**Ansprüche**

1. Strahlungshärtbares Zweischichtensystem, bestehend aus einer auf ein Substrat aufgebrachten, initiatorhaltigen Schicht und einer darüberliegenden, polymerisierbare Monomere oder Oligomere enthaltenden Schicht, dadurch gekennzeichnet, daß der Initiator an einer Makrostruktur immobilisiert ist.

2. Strahlungshärtbares Zweischichtensystem nach Anspruch 1, dadurch gekennzeichnet, daß der Initiator durch kovalente Bindung immobilisiert ist.

3. Strahlungshärtbares Zweischichtensystem nach Anspruch 1, dadurch gekennzeichnet, daß der Initiator kovalent an eine Polymermatrix gebunden ist.

4. Strahlungshärtbares Zweischichtensystem nach Anspruch 1, dadurch gekennzeichnet, daß der Initiator kovalent an die Substratoberfläche gebunden ist.

5. Verfahren zur Herstellung von polymeren Beschichtungen aus einem Zweischichtensystem nach Anspruch 1, indem durch Belichtung eine an die initiatorhaltige Schicht angrenzende, von der Dicke der Monomeren-oder Oligomerenschicht weitgehend unabhängige und nahezu homogene photopolymerisierte Schicht erzeugt wird und die darüberliegende, nicht polymerisierte Schicht durch Waschen entfernt wird.

6. Verfahren zur Herstellung von Reliefstrukturen aus einem Zweischichtensystem nach Anspruch 1, indem durch Belichtung durch eine Kopierschicht hindurch eine an die initiatorhaltige Schicht angrenzende, von der Dicke der Monomeren-oder Oligomerenschicht weitgehend unabhängige und nahezu homogene photopolymerisierte Schicht erzeugt wird und die darüberliegende Schicht sowie die nicht der Bestrahlung ausgesetzten und somit nicht polymerisierten Bereiche durch Waschen entfernt werden.

7. Verfahren zur Herstellung von Wellenleiterstrukturen für die integrierte Optik aus einem Zweischichtensystem nach Anspruch 1, indem durch Belichtung, gegebenenfalls durch eine Kopierschicht hindurch, einer Monomeren-oder Oligomerenschicht, eine an die gegebenenfalls nicht lineare optische Eigenschaften aufweisende und/oder auf einem nichtlinear optischen Substrat befindliche, initiatorhaltige Schicht angrenzende, gegenüber den sie umgebenden Materialien einen unterschiedlichen Brechungsindex aufweisende Schicht erzeugt wird und die darüberliegende Schicht sowie die nicht der Bestrahlung ausgesetzten und somit nicht polymerisierten Bereiche durch Waschen entfernt.

Datum 20.08.87
Bereich/Abt. Patentabteilung
Unser Zeichen Dr. Hirsch-hu-3629543
☎ (0 61 51) 72 3452
Ihr Schr. vom
Ihre Zeichen

**MERCK**
**Merck Patent GmbH**

Postfach 4119, D-6100 Darmstadt 1
Frankfurter Straße 250
Telefon (0 61 51) 72-0
Telex 4 19 328 32 em d

Europäisches Patentamt
Erhardtstraße 27

8000 München 2

EPA - EPO - OEB
MÜNCHEN
Empfang bestätigt
Receipt acknowledged
Accusé reception
CD

EPA EPO-OEB
DG 1
Reçu:
31 AUG. 1987

Europäische Patentanmeldung 87111854.3
entsprechend P 36 29 543

In der Anlage wird eine neue Seite 6 überreicht mit der Bitte, diese anstelle der bisherigen Seite 6 in die Anmeldungsunterlagen aufzunehmen.

Auf dieser Seite wurde in Zeile 24 geändert:

... einer der Substituenten $R^6$, $R^7$, $R^8$ von H ...

Bei der ursprünglichen Formulierung:

... einer der Substituenten X, Y, Z von H ...

handelt es sich um einen offensichtlichen Fehler, da die betreffende Maßgabe, welche diese Zeile enthält, sich auf die Unterformel

$$-W-Si-R^6_aR^7_bR^8_c \qquad \text{(Seite 6, Zeile 13)}$$

bezieht, in der X, Y und Z nicht vorkommen. Außerdem sind in den Zeilen 10 bis 12 auf Seite 6 X, Y und Z schon klar und eindeutig definiert, wobei für X und Y die Bedeutung H ohnehin nicht vorgesehen ist (Definitionen Seite 5, Zeilen 12 und 13).

Merck Patent GmbH

ppa. i. V.

Naumann Dr. Schüttler

Anlagen
Neue Seite 6 (dreifach)
Eingangsbestätigung